Europäisches Patentamt

European Patent Office

Office européen des brevets

(19)

(11) Publication number: **0 267 722**
**A2**

(12) **EUROPEAN PATENT APPLICATION**

(21) Application number: **87309684.6**

(22) Date of filing: **02.11.87**

(51) Int. Cl.4: **G01R 13/28**

(30) Priority: **10.11.86 US 928940**

(43) Date of publication of application:
**18.05.88 Bulletin 88/20**

(84) Designated Contracting States:
**DE FR GB**

(71) Applicant: **Hewlett-Packard Company**
**P.O. Box 10301 3000 Hanover Street**
**Palo Alto California 94303-0890(US)**

(72) Inventor: **Johnson, Dana L.**
**1131 North Foote Avenue**
**Colorado Springs Colorado 80909(US)**

(74) Representative: **Colgan, Stephen James et al**
**CARPMAELS & RANSFORD 43 Bloomsbury**
**Square**
**London WC1A 2RA.(GB)**

(54) **Probability density histogram display.**

(57) Disclosed is a probability density histogram display (200A,210A,220A,230A,310) for a digital oscilloscope (5) which shows a probability density histogram display of an input signal waveform alongside the conventional voltage-versus-time time-domain display (200,210,220,230,305) of the waveform. The histogram (315) shows the relative frequency of occurrence of voltage amplitude levels of the waveform (300). The histogram is optional and shown simultaneously with the time-domain display of the waveform.

FIG 4

EP 0 267 722 A2

# PROBABILITY DENSITY HISTOGRAM DISPLAY

## BACKGROUND OF THE INVENTION

A digital oscilloscope is used to capture, analyze and display electronic signal waveforms. The digital oscilloscope samples the voltage amplitude of an input signal and performs an analog-to-digital conversion (ADC) of the voltage values of the acquired samples. The digitized information is stored in memory and then used to create the display of the input signal's waveform on a cathode ray tube (CRT) display screen. Conventionally, the oscilloscope display is one of voltage-versus-time where units of voltage amplitude are plotted along the vertical axis and units of time are plotted along the horizontal axis. Typically, a wide selection of both voltage and time scale ranges is available to the user. The conventional voltage-versus-time plot may be regarded as a time-domain display of the input signal waveform. The time-domain display provides the user with critical phase and frequency information for a given input signal waveform.

The time-domain display, however, does not provide a complete display of the waveform. In particular, the relative frequency of occurrence of waveform voltage amplitude levels is not readily discernible in the time-domain. Determining the frequency of occurrence of amplitude levels is critical for several reasons. For instance, in pulse waveform analysis it is necessary to determine the base and top magnitudes, that is, amplitude levels, of the pulse. The base and top magnitudes of a pulse provide amplitude information used to establish the distal, mesial, and proximal lines. These lines typically designate the 90 percent, 50 percent and 10 percent values, repsectively, of the pulse amplitude. These values are used extensively in timing analysis. For instance, the risetime of a pulse is defined as the amount of time required for the pulse to rise from 10 percent to 90 percent of its final amplitude value.

A standardized technique for determining the base and top magnitudes of a pulse waveform requires the computation and analysis of a probability-density histogram of the pulse data. (This standardized technique is described in the Institute of Electrical and Electronic Engineers (IEEE) Standard 181-1977, Section 4.3, entitled Pulse Measurement and Analysis by Objective Techniques.) The probability-density histogram is essentially an analytical bar-chart giving the frequency of occurrence of amplitude levels. The probability-density histogram may be regarded as a probability-domain analysis of a waveform in contrast to the conventional voltage-versus-time time-domain display of an oscilloscope. Conventionally, the probability-domain analysis, if performed, is invisible to the user of the oscilloscope.

## SUMMARY OF THE INVENTION

The present invention makes the probability-domain histogram analysis visible to the digital oscilloscope user with a probability-density histogram display. The probability-density histogram display is a bar-chart showing the frequency of occurrence of voltage amplitude levels of a given input signal waveform. As a visual display, the histogram allows the viewer to determine, at a glance, the relative probability that a waveform occupies a given voltage amplitude level. The present invention allows the user the option of viewing the waveform in the time-domain and probability-domain simultaneously. The time-domain display is the conventional voltage-(amplitude)-versus-time display. The probability-domain display is a voltage(amplitude)-versus-probability display, where the probability axis is simply a scale of numerical values between zero and one. Hence, the histogram shows the probability that the waveform occupies a voltage(amplitude) level measured along the voltage(amplitude) axis. In the preferred embodiment of the present invention, the probability-domain display is adjacent to the time-domain display and configured such that the voltage(amplitude) axis in the time-domain is parallel and identical to the voltage(amplitude) axis in the probability-domain. Moreover, the distal and proximal lines, that is, the 90 percent and 10 percent lines, are shown as dashed horizontal lines across the displays of both domains.

There are signifcant advantages to viewing a signal waveform in the probability-domain and time-domain simultaneously. First, the oscilloscope user gains important insight into how the top and base amplitudes, and hence the distal and proximal lines, are computed for particular waveforms. For instance, the histogram technique, that is, IEEE Standard 181-1977, is generally very reliable except for waveforms without signficant durations at the top and base magnitudes. For these exceptional waveforms, reliance on the histogram analysis may adversely affect the accuracy and repeatability of measurements. A quick view of the waveform's histogram, that is, a view of the waveform in the probability-domain, will alert the user to those waveforms which lack significant durations at the top and base magnitudes. The user may then take corrective action to improve the measurement such as rewindowing the data so that the top and base can be more accurately determined or overriding automatic distal and proximal line computation with user-entered data. Secondly, waveform distortions may be more obvious in the probability-domain. For instance, ideal periodic waveforms, such as sine waves, triangular waves, square waves and so on, have characteristic histograms. For such waveforms, irregularities which are unobvious in the time-domain are quite detectable in the probability-domain. For example, the probability-density histogram for a perfect triangle wave is essentially a straight horizontal bar. Whereas slight non-linearities in the ramps of the triangle wave may be undetectable in the time-domain, such non-linearity will appear as a distinct glitch in the histogram. The histogram for such a triangle wave will also be dipped, where it would otherwise be straight, in direct proportion to the degree of non-linearity in the time-domain.

Hence, the optional, simultaneous probability-density histogram allows the oscilloscope user increased waveform measurement confidence and provides immediate visual alerts to subtle waveform distortions which may otherwise go undetected.

BRIEF DESCRIPTION OF THE DRAWINGS

Figure 1 shows a general overview of a digital oscilloscope.

Figure 2 shows a functional diagram of the digital oscilloscope of Figure 1.

Figure 3 shows the sampling of an input signal and the storage and display in time-buckets of the digitized sample information.

Figure 4 shows a sample display of the present invention.

Figure 5 shows a graphical depiction of the construction of the probability-density histogram.

Figure 6 shows how the conceptual teaching of Figure 5 is implemented in the present invention.

DESCRIPTION OF THE PREFERRED EMBODIMENT

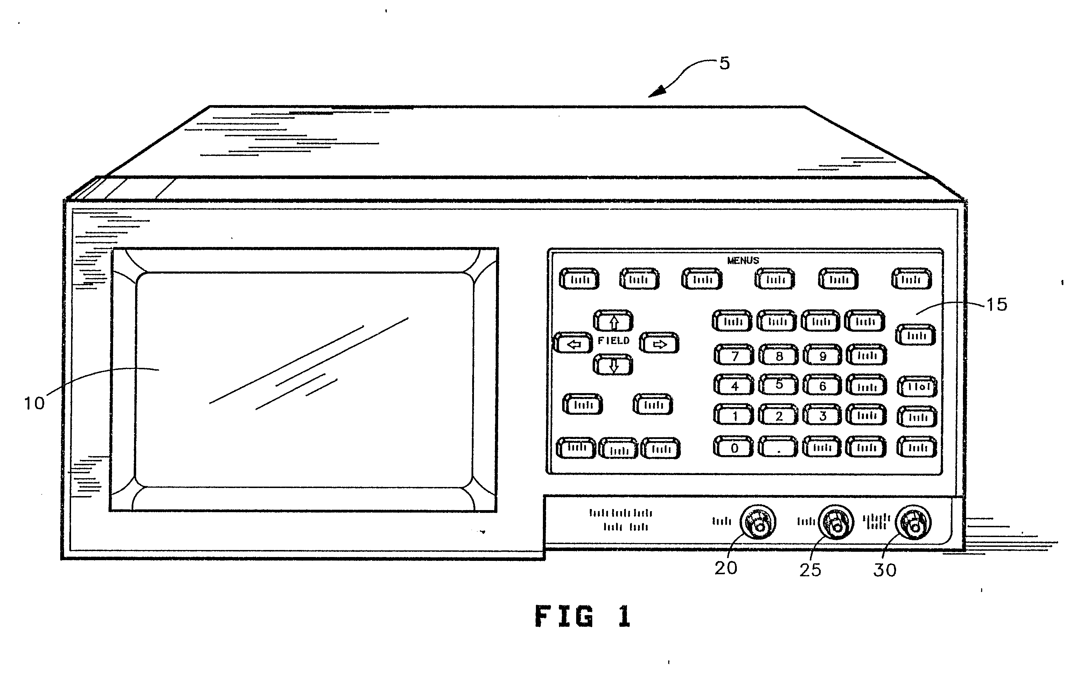

Figure 1 is a general overview of digital oscilloscope 5 such as may incorporate the present invention. Oscilloscope 5 is operated and controlled by the user with menu keyboard 15. Trigger signals for reference and input signals for display are received at ports 20, 25 and 30. Input signal waveforms are viewed on display screen 10.

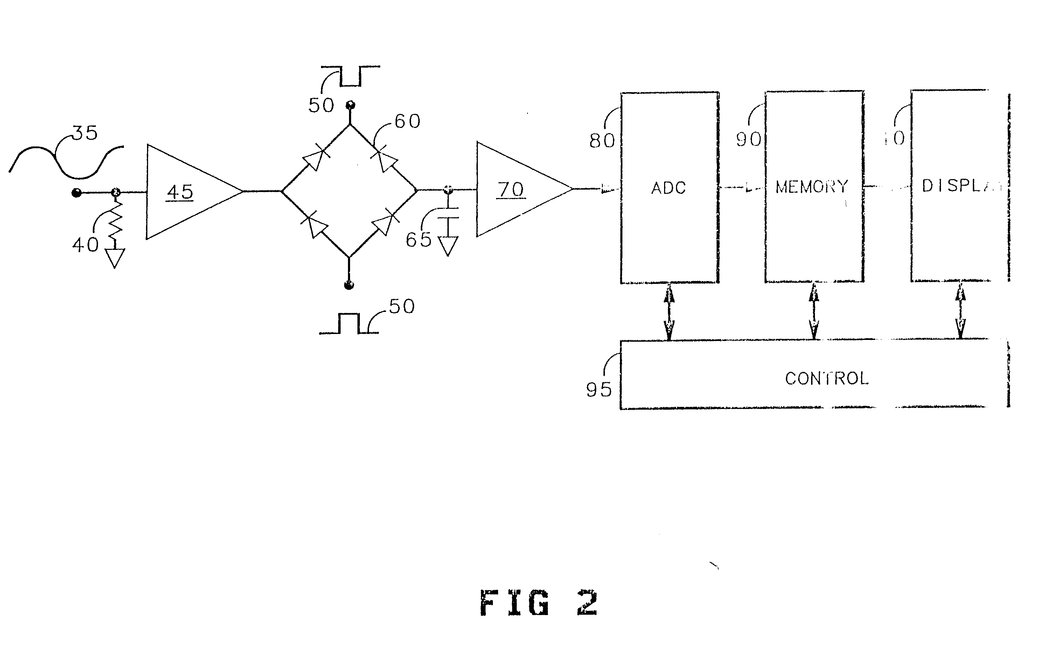

Figure 2 is a functional overview of digital oscilloscope 5. Sensing circuit 40 detects input signal 35. Signal 35 is buffered by pre-amp 45 and applied to sampling bridge 60. Sample-clock pulse 50 drives sampling bridge 60 in such a way that a sample of the voltage value of input signal 35 is passed on to holding circuit 65 with each period of sample-clock 50. Post-amp 70 then delivers the voltage values from holding circuit 65 to analog-to-digital converter 80 (ADC). ADC 80 converts the sample voltage values to digital words such that each signal sample is represented by a single digital word. The digitized samples produced by ADC 80 are stored in memory 90. The digitized information can be analysed in the computation of the probability-density histogram. This digital information is mapped from memory 90 to display screen 10 to create a display of the probability-density histogram of the waveform of signal 35. Control circuitry 90 governs the interaction of ADC 80, memory 90 and display screen 10.

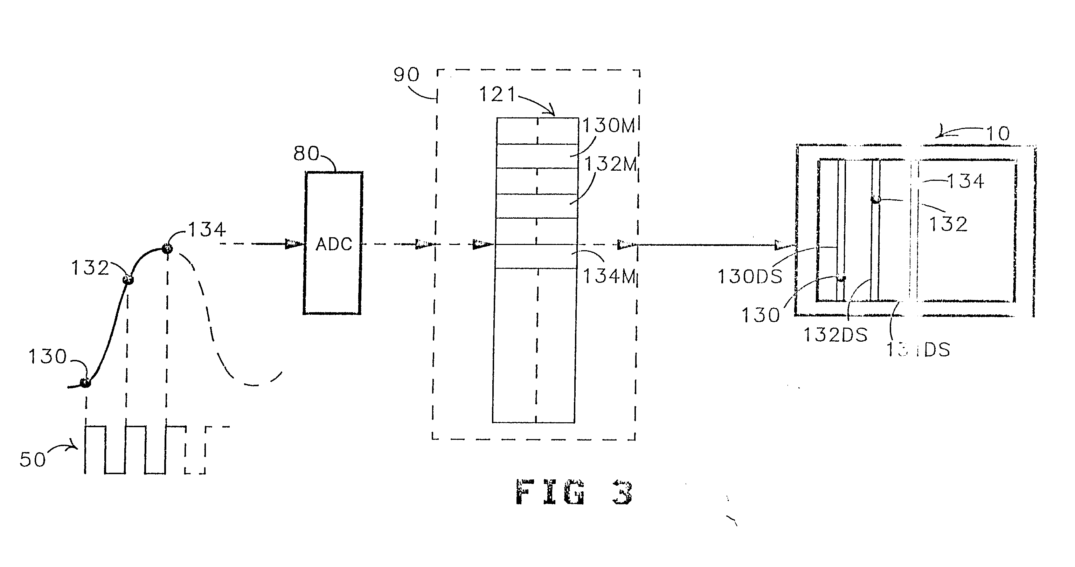

Figure 3 shows the sampling of an input signal 35 and the storage and display in time-buckets of the digitized information. Input signal 35 is sampled on the rising edge of each pulse of sample-clock 50. Typical sample points 130, 132, and 134 are digitized by ADC 80 and stored in waveform buffer 121 in time-buckets 130M, 132M and 134M, respectively. Time-buckets 130M, 132M and 134M are implemented as digital bytes in waveform buffer 121. The sample point data may then be mapped from waveform buffer 121 time-buckets 130M, 132M, and 134M to corresponding display screen 10 time-buckets 130DS, 132DS and 134DS, repsectively. Display screen 10 time-buckets may be implemented as pixel columns. In the preferred embodiment of the present invention there are 1001 bytes, that is time-buckets, in waveform buffer 121 so that 1001 sample points may be digitized for the display of a single waveform. On the other hand, it is not necessary to have a one-to-one correspondence between the time-buckets(bytes) of waveform buffer 121 and the time-buckets(pixel columns) of display screen 10. For instance, the 1001 time-buckets of waveform buffer 121 may be compressed into fewer than 1001 pixel columns in display screen 10 by averaging adjacent time-buckets in waveform buffer 121.

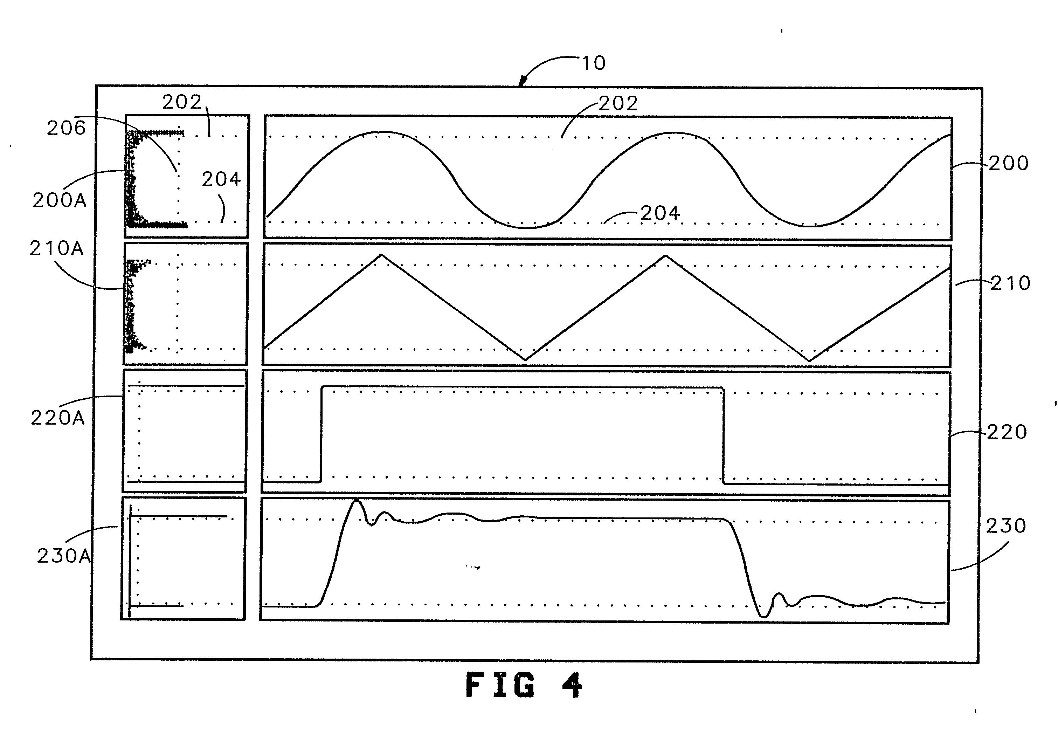

Figure 4 shows a sample display of the present invention. In the preferred embodiment of the present invention, display screen 10 can accommodate four sub-display channels at once. This allows for the simultaneous display of four input signals. In the preferred embodiment of the present invention, the time-domain display of an input signal is shown on the right-hand side of display screen 10 and its corresponding probability-domain display is shown adjacently to the left of the time-domain display. A sine wave is shown in time-domain display 200 and its corresponding probability-domain display 200A is adjacent to the left. Likewise, a triangle wave is shown in time-domain display 210 and its corresponding probability-domain display 210A is adjacent to the left. Likewise, probability-domain display 220A corresponds to the pulse in time display 220 and probability-domain display 230A corresponds to the noisy pulse of time-domain display 230. In the preferred embodiment of the present invention, as shown in Figure 4, the probability-domain and time-domain displays for a single waveform are adjacent and configured such that the voltage(amplitude) axis in the probability-domain display is identical and parallel to the voltage(amplitude) axis in the time-domain display. As shown in Figure 4, the voltage(amplitude) axis is the vertical axis in both the probability and the time domain. The horizontal axis in the time-domain measures time. The horizontal axis in the probability-domain is a scale of numerical values between zero and one, indicating degree of probability between zero percent and one-hundred- percent, repsectively. The time-domain displays 200, 210, 220, and 230 provide phase and frequency information for their respective waveforms while probability-domain displays 200A, 210A, 220A, and 230A provide probability-density histograms. The histograms indicate the frequency of occurrence of voltage(amplitude) levels of their corresponding time-domain waveforms. Hence, the length of a horizontal bar at a given voltage(amplitude) level in a probability-domain display indicates the probability, between zero and one-hundred percent, that the waveform shown in the adjacent time-domain display occupies that voltage(amplitude) level. In the preferred embodiment of the present invention, the distal and proximal lines, that is, the 90 percent and 10 percent lines, are shown as dashed horizontal lines in both the probability-domain and the time-domain, such as distal line 202 and proximal line 204 in time-domain 200 and probability-domain 200A. In all cases, the voltage(amplitude) level of the distal and proximal lines in a given time-domain will match the levels of the distal and proximal lines in the corresponding probability-domain because the domains have identical voltage(amplitude) axes. In addition, the count threshold is shown as a dashed vertical line in each probability-domain, such as count threshold line 206 in probability-domain 200A. The count threshold is simply a pre-determined percentage of all the sample points in waveform buffer 121, such as ten percent. The count threshold defines the minimum number of points in waveform buffer 121 which must equal or exceed a given voltage(amplitude) level before that level can be candidate for the top or base magnitude of a given waveform.

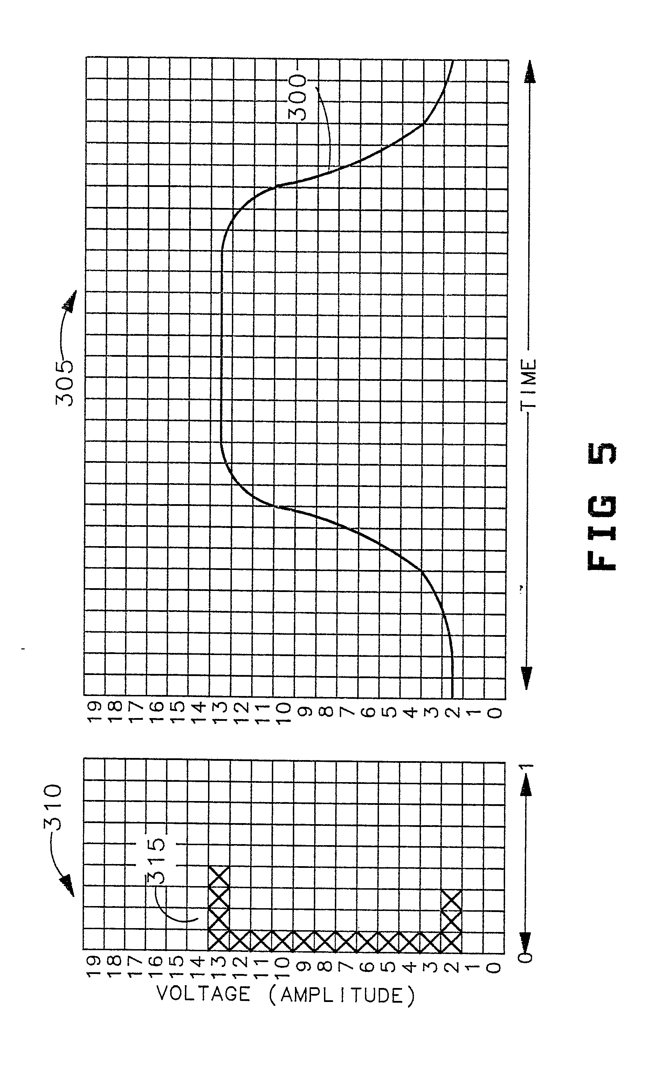

Figure 5 is graphical depiction of the construction of the probability-density histogram. Pulse waveform 300 may be grahpically superimposed on gridded time-domain 305. Time-domain display 305 has a vertical voltage(amplitude) axis and a horizontal time axis. Probability-domain 310 is adjacent to the left of time-domain 305. Probability-domain 310 has a vertical voltage(amplitude) axis and a horizontal probability axis, that is, the horizontal axis is simply a scale of numeral values between zero and one. The voltage(amplitude) axis of probability-domain 310 is indentical to the voltage(amplitude) axis of time-domain 305. Probability-density histogram 315 in probability-domain 310 corresponds to waveform 300 in time-domain 305. Histogram 315 indicates the frequency of occurrence of voltage(amplitude) levels for waveform 300. Histogram 315 is constructed as follows. At each voltage(amplitude) level in time-domain 305, a count is made of the number of grid squares that waveform 300 intersects across the time-domain at that level. At the corresponding voltage(amplitude) level in probability-domain 310, a proportionate number of grid squares are marked. Since the vertical voltage(amplitude) axes are identical, the proportionate relationship between the counts in time-domain 305 and the number of marked squares in probability-domain 310 is simply the ratio of the horizontal lengths of each domain, as measured in grid squares. In Figure 5, the ratio is 3:1 such that at each voltage(amplitude) level, three squares in time-domain 305 correspond to one square in probability-domain 310. For instance, at voltage(amplitude) level 13, waveform 300 intersects twelve sqaures in time-domain 305; therefore, four sqaures are marked at level 13 in probability domain 310. Likewise, at level 6, waveform 300 intersects only two squares in time-domain 305, so that at most only one square is marked at level 6 in probability-domain 310. Likewise, at level 2, waveform 300 intersects nine squares in time-domain 305 so that three squares are marked in probability-domain 310 at level 2. Similar calculations at each voltage(amplitude) level result in construction of probability-domain histogram 310. The graphical concept of Figure 5 is discussed in Section 4.3.1 of IEEE Standard 181-1977, entitled Pulse Measurement and Analysis byObjective Techniques.

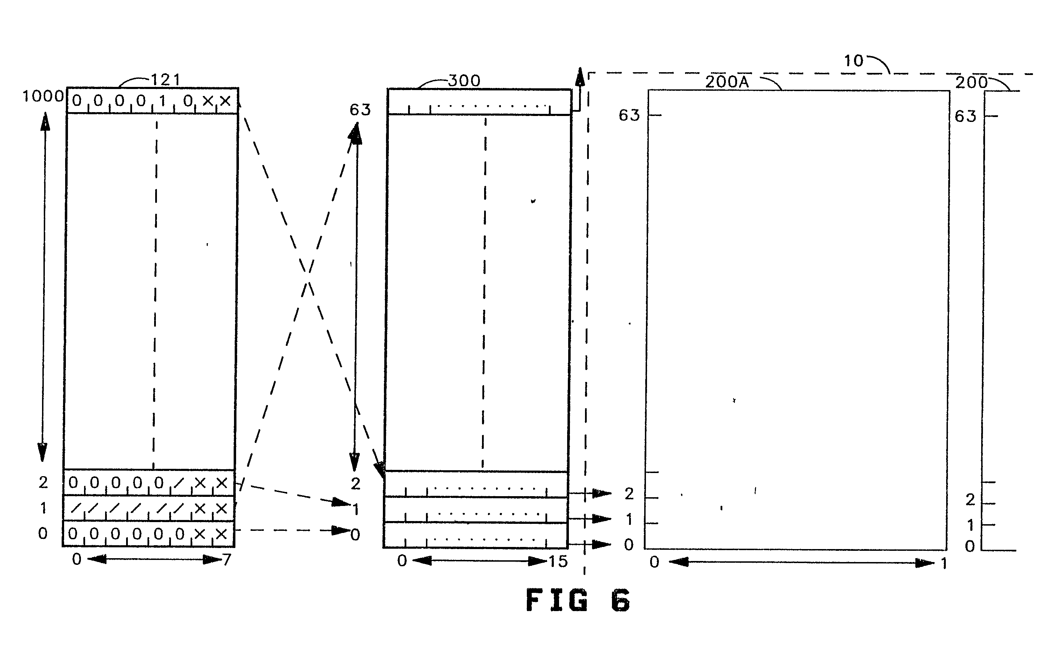

Figure 6 shows how the conceptual teaching of Figure 5 is implemented in the present invention. The digitized sample values stored in the bytes of waveform buffer 121 constitute a digital representation of the input signal waveform. Each byte is a single time-bucket. In the preferred embodiment of the present invention, the digital value of a time-bucket represents the amplitude of a sample point. The ordinal position of the time-bucket in waveform buffer 121 corresponds to that sample's position in time in the time-domain.

Since each time-bucket is an 8-bit byte, the amplitude value of a sample point is resolvable into $2^8$ = 64 levels. Hence, the voltage(amplitude) axis of both the probability-domain and the time-domain displays is resolvable into sixty-four discrete voltage(amplitude) levels. A bank 300 of sixty-four 16-bit counters provides a 16-bit counter for each (voltage)amplitude level. Prior to filling waveform buffer 121 with sample point data, the counters are cleared. Then waveform buffer 121 is filled with sample point data and then read, one time-bucket at a time. For each of the sixty-four possible voltage(amplitude) levels per time-bucket, the appropriate corresponding counter in bank 300 is incremented. For instance, as shown in Figure 6, if time-bucket #0 in waveform 121 contains the digital value zero, then counter #0 in bank 300 is incremented; if time-bucket #1 contains the value sixty-three, then counter #63 is incremented; if time-bucket #2 contains the value one, then counter #1 is incremented; and so on throughout the 1001 time-buckets of waveform buffer 121. If a value occurs more than once in waveform buffer 121, then the counter correpsonding to that value is incremented each time that value occurs. For instance, suppose that time-buckets #100 through #700 of the 1001 time-buckets of waveform buffer 121 each contained the value forty-eight, while the remaining time-buckets contained the value sixteen, as might be the case with a long duty-cycle pulse, similar to the pulse in time-domain 220 of Figure 4. In such a case, counter #48 in bank 300 would be incremented (700 - 100) + 1 = 601 times; counter #16 would be incremented (1001 - 601) = 400 times; and the remaining counters would remaine zeroed. (Since each counter has sixteen bits, each counter may be incremented $2^{16}$ = 65,536 times. However, since ther are only 1001 time-buckets in waveform buffer 121, the highest count value any counter will contain, in the preferred embodiment, is 1001. The extra resolution of the counters allows for growth in the length of the waveform buffer.) When all the time-buckets of waveform buffer 121 have been read and the corresponding 16-bit counters have been iuncremented, the histogram for that particular waveform is essentially contained in bank 300. In display of the histogram, the final incremented value of each of the sixty-four counters corresponds directly to the horizontal length of the bar-element of the histogram at the corresponding voltage(amplitude) level on the display. In mapping the digital information of bank 300 onto probability-domain display 200A, conventional horizontal auto-scaling may be employed to ensure, at any of the sixty-four voltage amplitude levels, that the largest count value of any of the sixty-four counters corresponds to the longest horizontal histogram bar-element. Auto-scaling thus ensures that all of the information in bank 300 is mapped onto the probability-domain display to produce a properly shaped histogram.

## Claims

1. a display (10) for viewing and analysis of the waveform of an input signal to a digital oscilloscope (5), comprising:

a time-domain sub-display (200, 210, 220, 230, 305) for displaying the waveform (300) in the time domain; and

a probability-domain sub-display (200A, 210A, 220A, 230A, 310), corresponding to said time-domain sub-display, for displaying, simultaneously with said time-domain display, a probability-density histogram (315) of the waveform, said histogram showing the relative frequency of occurrence of voltage amplitude levels of said waveform.

FIG 1

0 267 722

FIG 2

0 267 722

FIG 3

0 267 722

FIG 4

0 267 722

FIG 5

0 267 722

1000

121

0 0 0 0 1 0 × ×

2 0 0 0 0 0 / × ×

1 / / / / / × ×

0 0 0 0 0 0 0 × ×

0 7

300

63

2

1

0

0 15

10

200A

200

63

63

2

1

0

0 1

# FIG 6